Europäisches Patentamt

European Patent Office

Office européen des brevets

(19)

(11) Veröffentlichungsnummer: **0 012 839**
**B1**

(12) **EUROPÄISCHE PATENTSCHRIFT**

(45) Veröffentlichungstag der Patentschrift: **26.10.83**

(51) Int. Cl.³: **G 05 F  1/46,  H 03 K  5/13**

(21) Anmeldenummer: **79104583.4**

(22) Anmeldetag: **19.11.79**

(54) **Verfahren zur Angleichung der unterschiedlichen Signalverzögerungszeiten von Halbleiterchips durch Verändern einer Betriebsspannung und Vorrichtung zur Durchführung des Verfahrens.**

(30) Priorität: **22.12.78 DE  2855724**

(43) Veröffentlichungstag der Anmeldung:
**09.07.80 Patentblatt 80/14**

(45) Bekanntmachung des Hinweises auf die Patenterteilung:
**26.10.83 Patentblatt 83/43**

(84) Benannte Vertragsstaaten:
**DE FR GB**

(56) Entgegenhaltungen:
**FR - A - 2 346 765**
**US - A - 3 931 588**
**US - A - 3 970 919**

**IBM TECHNICAL DISCLOSURE BULLETIN, Band 17, Nr. 10, März 1975, New York, US PARISI et al. "Speed normalization of logic circuits", Seiten 2913—2914**

(73) Patentinhaber: **International Business Machines Corporation**
**Old Orchard Road**
**Armonk, N.Y. 10504 (US)**

(72) Erfinder: **Schettler, Helmut**
**Jägerstrasse 23**
**D-7405 Dettenhausen (DE)**
Erfinder: **Brosch, Rudolf, Dr.**
**Seestrasse 104**
**D-7032 Sindelfingen (DE)**
Erfinder: **Zuehlke, Rainer, Dr.**
**Rainstrasse 3**
**D-7250 Leonberg 7 (DE)**
Erfinder: **Schumacher, Hans, Dr.**
**Kimbernstrasse 75**
**D-7036 Schönaich (DE)**

(74) Vertreter: **Neuland, Johannes, Dipl.-Ing.**
**Schönaicher Strasse 220**
**D-7030 Böblingen (DE)**

Verfahren zur Angleichung der unterschiedlichen Signalverzögerungszeiten von
Halbleiterchips durch Verändern einer Betreibsspannung und Vorrichtung
zur Durchführung des Verfahrens

Die Erfindung bezieht sich auf ein Verfahren zur Angleichung der unterschiedlichen Signalverzögerungszeiten von Halbleiterchips durch Verändern einer Betriebsspannung, deren Größe die Signalverzögerungen der Schaltungen des Halbleiterchips beeinflußt. Weiter bezieht sich die Erfindung auch auf eine Vorrichtung zur Ausführung dieses Verfahrens. Aufgrund von Fertigungstoleranzen weisen Halbleiterchips verhältnismäßig große Unterschiede hinsichtlich der Signalverzögerung auf. In einem mit derartigen Halbleiterchips aufgebauten synchron arbeitenden Netzwerk, wie es beispielsweise in programmgesteuerten digitalen Rechenanlagen mit Parallelverarbeitung vorliegt, machen sich die unterschiedlichen Signalverzögerungen insofern nachteilig bemerkbar, als sich die Wahl der Taktfrequenz nach den Halbleiterchips mit der größten Signalverzögerung richten muß. Große Laufzeitunterschiede bei Impulsen, die eigentlich gleichzeitig am Empfänger eintreffen sollten, bedeuten zusätzlich Schwierigkeiten beim Entwurf der Logik.

Aus der Veröffentlichung von J. A. Parisi und J. A. Petrosky "Speed Normalization of Logic Circuits" im IBM Technical Disclosure Bulletin, Vol. 17, Nr. 10, März 1975, Seiten 2913 und 2914 ist es bekannt, die unterschiedlichen Signalverzögerungszeiten von Halbleiterchips, in denen die Kollektor-Substratkapazität der dominierende Parameter für die Signalverzögerung ist, durch die unterschiedliche Größe der Substratvorspannung für die verschiedenen Halbleiterchips einander anzugleichen.

Die Erfindung, wie sie in den Ansprüchen gekennzeichnet ist, löst die Aufgabe, nicht nur in den Fällen, in denen die Kollektor-Substratkapazität der dominierende Parameter für die Signalverzögerung ist, ein Angleichen der Signalverzögerungszeiten der verschiedenen Halbleiterchips zu gewährleisten, sondern im jedem Fall.

Die durch die Erfindung erreichten Vorteile sind im wesentlichen darin zu sehen, daß das Angleichen der unterschiedlichen Signalverzögerungszeiten verschiedener Halbleiterchips die Wahl einer höheren Taktfrequenz erlaubt, was zu einer Verringerung der Rechenzeiten führt. Da außerdem die Erfahrung zeigt, daß die Stromaufnahme eines Halbleiterchips seiner Signalverzögerung nahezu proportional ist, werden mit dem Angleichen der Signalverzögerungszeiten der Chips auch deren Werte für die Stromaufnahme einander angeglichen. Dadurch können auch die Anforderungen an die Stromversorgungsgeräte gemildert werden, wodurch deren Kosten und Komplexität herabgesetzt werden.

Im folgenden wird die Erfindung in Verbindung mit den Zeichnungen häher erläutert, von denen zeigen:

Fig. 1 ein größtenteils als Blockschaltbild ausgeführtes Schaltbild der Vorrichtung zur Ausführung des Verfahrens nach der Erfindung;

Fign. 2A u. 2B Impulsdiagramme zur Erläuterung der Arbeitsweise der einen Teil der Vorrichtung nach Fig. 1 bildenden Vergleichsschaltung;

Fig. 3 den Aufbau eines zur Vorrichtung nach Fig. 1 gehörenden Decodierers;

Fig. 4 die den Aufbau des Decodierers bestimmende Funktionstabelle und

Fig. 5 eine Tabelle, die die erregten Ausgangsleitungen des Decodierers in Abhängigkeit vom Zählerstand eines zur Vorrichtung nach Fig. 1 gehörenden dreistufigen Zweirichtungszählers wiedergibt.

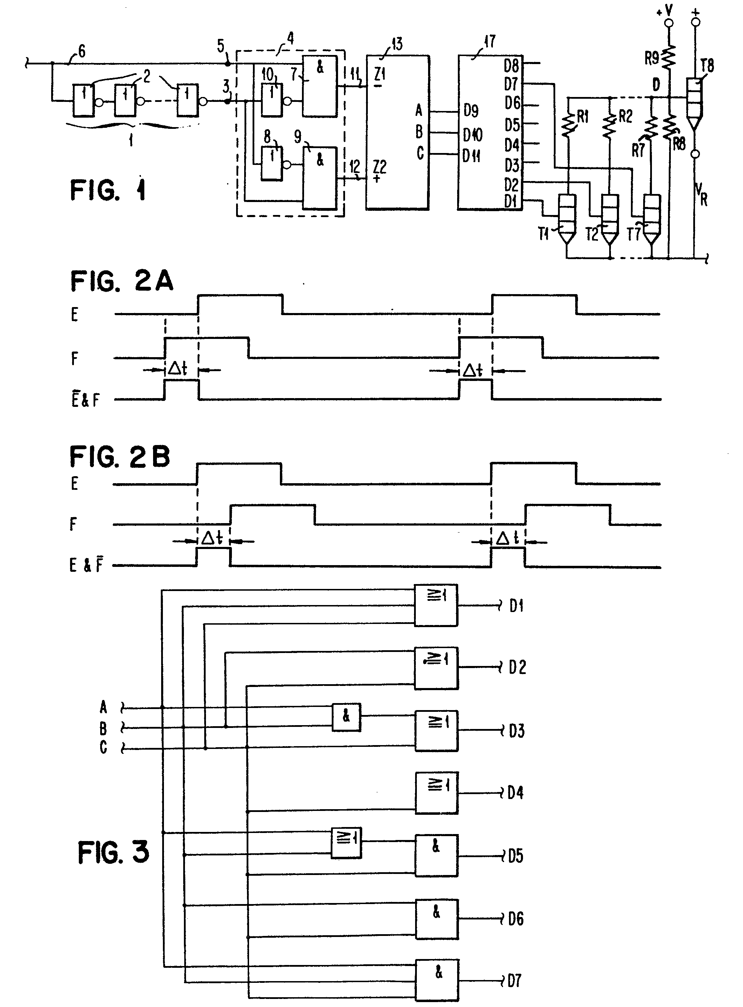

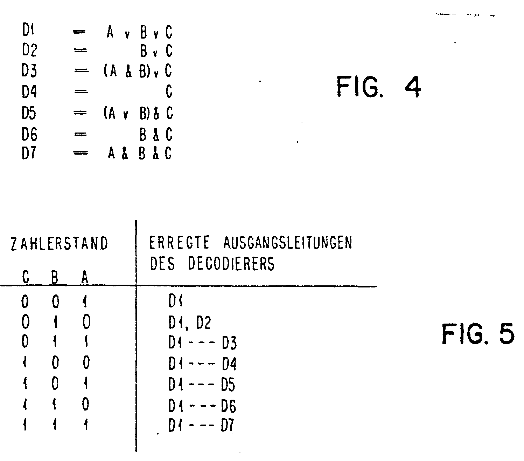

In Fig. 1 ist mit 1 eine Kette von aufeinanderfolgenden Nicht-Gliedern 2 bezeichnet, deren Anzahl so gewählt wurde, daß die durch die Kette erzielbare Gesamt-Signalverzögerung etwa dem zeitlichen Abstand zweier Taktimpulse entspricht, die in der Rechenanlage zur Synchronisation der Operationen verwendet werden. Beträgt das Taktintervall beispielsweise 100 ns und die Signalverzögerung eines einzelnen Nicht-Gliedes etwa 5 ns, so sind 20 Nicht-Glieder für die Kette 1 erforderlich. Der Ausgang des letzten Nicht-Gliedes führt an den ersten Eingang 3 einer Vergleichsschaltung 4, die von einer Strichlinie umgeben ist. Der zweite Eingang 5 der Vergleichsschaltung ist mit einer Taktleitung 6 verbunden, an die auch das erste Nicht-Glied der Kette 1 angeschlossen ist. Der zweite Eingang 5 der Vergleichsschaltung 4 führt an ein UND-Glied 7 und über ein Nicht-Glied 8 an ein UND-Glied 9. Der erste Eingang 3 der Vergleichsschaltung 4 ist über ein Nicht-Glied 10 an den zweiten Eingang des UND-Gliedes 7 und direkt an den zweiten Eingang des UND-Gliedes 9 angeschlossen. Die beiden Ausgänge 11 und 12 der Vergleichsschaltung 4 führen an die beiden Steuereingänge Z1 und Z2 eines dreistufigen Zweirichtungszählers 13. Dessen Eingang Z2 zugeführte Impulse erhöhen den Zählerstand, der durch zum Eingang Z1 gelangende Impulse erniedrigt wird. Die drei Ausgänge A, B und C des Zweirichtungszählers 15 führen zu den Eingängen D9, D10 und D11 eines Decodierers 17. Wie aus Fig. 3 in Verbindung mit den Fign. 4 und 5 hervorgeht, ist der Decodierer 17 so aufgebaut, daß stets so viele seiner Ausgänge ein gewünschtes Potential aufweisen als dem Zählerstand des Zählers 13 entsprechen. Von den Ausgängen D1 bis D7 des Decodierers 17 ist jeweils einer an die Basis eines der Transistoren T1 bis T7 angeschlossen, die mit ihren Kollektorwiderständen R1 bis R7 alle parallel zum unteren Widerstand R8 eines aus den Widerständen R9 und R8 gebildeten Spannungsteilers liegen, der an den positiven Pol+V der Bestriebsspannungsquelle angeschlossen ist. Der Abgriff D des Spannungsteilers ist mit der Basis eines Regeltransistors T8 verbunden, dessen Kollektor ebenfalls an den positiven Pol+V der Betriebsspannungsquelle angeschlossen ist. Zwischen dem Bezugspotential und dem Emitter von T8 steht die Spannung $V_R$ zur Verfügung, welche die Signalverzögerung der von ihr gespeisten Schaltungen beeinflußt, zu denen auch die Kette 1 der Nicht-Glieder 2 gehört, während der Vergleicher 4, der Zähler 13 und der Decodierer 17 auch an den positiven Pol+V der Betriebsspannungsquelle angeschlossen sein können. Die Widerstände R1 bis R9 sind dabei so gewählt, daß, unabhängig davon, wieviel der Transistoren T1 bis T7 aufgrund der Ausgangsspannungen des Decodierers 17 leitend sind, der Transistor T8 eine Spannung $V_R$ abgibt, bei der die Schaltkreise, deren Signalverzögerung verändert werden soll, noch bestimmungsgemäß arbeiten. Dies bedeutet, daß die Spannung $V_R$ so begrenzt wird, evt. durch Begrenzerschaltungen, daß die zur Funktionsfähigkeit des Chips erforderlichen spannungswerte $V_{Rmax}$ und $V_{Rmin}$ nicht über- oder unterschritten werden.

Die Wirkungsweise der Vorrichtung nach Fig. 1 ist folgende: Beim Anlegen der Versorgungsspannung +V fällt der Zähler 13 in einen beliebigen Anfangszustand, der beispielsweise dem Zählerstand 4 entspreche. Das bedeutet, daß die Ausgangsleitungen D1 bis D4 des Decodierers ein positives Potential aufweisen. Daher werden die Transistoren T1 bis T4 leitend und ihre Kollektorwiderstände R1 bis R4 dem Widerstand R8 des Spannungsteilers R9/R8 parallel geschaltet. Damit steht zwischen dem Bezugspotential und dem Emitter des Transistors T8 eine bestimmte Spannung $V_R$ zur Verfügung, die mit Ausnahme des Spannungsteilers R9/R8 und des Transistors T8, die an die Betriebsspannung +V angeschlossen sind, den übrigen Schaltungen des Chips zugeleitet wird.

Sobald nun die Taktimpulse eintreffen, beginnt das Angleichen der Signalverzögerung des Halbleiterchips an das Taktintervall in folgender Weise:

Der erste auf der Leitung 6 eintreffende Taktimpuls gelangt vom Eingang der Vergleichsschaltung 4 direkt an den ersten Eingang des UND-Gliedes 7 und ebenso über das nur eine vernachlässigbare Signalverzögerung aufweisende Nicht-Glied 8 an den ersten Eingang des UND-Gliedes 9. Ferner durchläuft er die Kette 1 aus Nicht-Gliedern 2 und gelangt zum Eingang 3 der Vergleichsschaltung 4. In dieser wird festgestellt, ob der nachfolgende, direkt dem Eingang 5 der Vergleichsschaltung 4 zugeführt Taktimpuls früher oder später als der durch die Kette 1 verzögerte vorausgehende Taktimpuls sort eintrifft. Trifft der verzögerte, in Fig. 2 mit F bezeichnete Taktimpuls später an der Vergleichsschaltung 4 ein als der nachfolgende unverzögerte Taktimpuls E, so liefert die Vergleichsschaltung an ihrem Ausgang 11 einen Impuls E & $\overline{F}$ (Fig. 2B), dessen Dauer dem Zeitintervall Δt entspricht, um das der durch die Kette 1 verzögerte Taktimpuls F später am Vergleicher eintrifft als der nachfolgende unverzögerte Taktimpuls E (Fig. 2B). Das bedeutet, daß die Signalverzögerung des Halbleiterchips größer als der erwünschte Wert ist. Der Ausgangsimpuls der Vergleichsschaltung wird daher dem Rückwärts-Zähleingang Z1 des Zählers 13 zugeführt. Dadurch verringert sich der Zählerstand um 1, d.h., es weisen jetzt nur noch drei Ausgänge des Decodierers das hohe Potential auf. Damit sind nur noch drei Transistoren T1 bis T3 leitend und es liegen nur noch die Widerstände R1 bis R3 dem Widerstand R8 des Spannungsteilers parallel, so daß sich der resultierende Widerstand des unteren Teiles des Spannungsteilers erhöht. Das Basispotential des Transistors T8 steigt daher an und entsprechend auch die Spannung $V_R$ zum Betrieb der Schaltungen des Halbleiterchips. Mit höherer Betriebsspannung $V_R$ verringert sich aber die Signalverzögerung des Chips. Nach dem Erhöhen der Spannung $V_R$ wird der vorher beschriebene Vergleich zwischen einem verzögerten und dem nachfolgenden unverzögerten Taktimpuls erneut durchgeführt und der resultierende Widerstand des unteren Teiles des Spannungsteilers solange verändert, bis die gewünschte Verzögerung erreicht ist, d.h., bis die Differenz Δt zwischen dem verzögerten und nachfolgenden unverzögerten Taktimpuls gegen Null geht.

Ergibt der erste durchgeführte Vergleich, daß der verzögerte Taktimpuls F vor dem nachfolgenden unverzögerten Taktimpuls E an der Vergleichschaltung eintrifft (Fig. 2A), so ist die Signalverzögerung des Halbleiterchips zu klein und es erscheint am Ausgang 12 der Vergleichsschaltung ein Impuls $\overline{E}$ & F, der dem Vorwärts-Zähleingang Z2 des Zählers 13 zugeführt wird. Der Zählerstand wird um 1 erhöht und der Decodierer schaltet dann einen zusätzlichen Transistor ein und damit einen weiteren Widerstand dem unteren Teil des Spannungsteilers parallel, so daß infolge des verringerten resultierenden Widerstandes der Parallelschaltung das Basispotential des Transistors T8 und damit auch die an seinem Emitter auftretende Spannung $V_R$ erniedrigt wird. Mit der verringerten Spannung $V_R$ erhöht sich die Signalverzögerung der von ihr gespeisten Schaltungen. Auch in diesem Fall wird der Vergleich zwischen dem verzögerten Taktimpuls F und dem nachfolgenden unverzögerten E so oft durchgeführt, bis der gewünschte Wert für die Signalverzögerung erreicht ist und damit die Differenz Δt zwischen dem Eintreffen des verzögerten und dem nachfolgenden unverzögerten Taktimpulses gegen Null geht.

**Patentansprüche**

1. Verfahren zur Angleichung der unterschiedlichen Signalverzögerungszeiten von Halbleiterchips durch Verändern einer Betriebsspannung, gekennzeichnet durch folgende Verfahrensschritte:

a) Vergleichen der Signalverzögerung einer für des Angleichen zusätzlich auf dem Halbleiterchip vorgesehenen Kette (1) von Nicht-Gliedern (2) mit einem sehr genau definierten Taktintervall,

b) Ändern des Zählerstandes eines auf dem Halbleiterchip befindlichen Zweirichtungszählers (13) entsprechend dem Vergleichsergebnis in der einen oder der anderen Zählrichtung,

c) Decodieren des Zählerstandes und Ändern des Teilerverhältnisses eines Spannungsteilers in Abhängigkeit vom Zählerstand durch Zu- oder Abschalten von Parallelwiderständen (R1 bis R7), dessen Abgriff (D) an die Basis eines Emitterfolgers (T8) angeschlossen ist, an dessen Emitter die Betriebsspannung abnehmbar ist, deren Größe die Signalverzögerung der Schaltungen des Halbleiterchips beeinflußt und

d) Wiederholen der Verfahrensschritte a) bis c), bis die Differenz Δt zwischen dem Eintreffen des verzögerten und des nachfolgenden unverzögerten Taktimpulses gegen Null geht.

2. Vorrichtung zur Ausführung des Verfahrens nach Anspruch 1, dadurch gekennzeichnet, daß auf jedem Halbleiterchip vorgesehen sind,

a) eine Vergleichsschaltung (4) zum Vergleich der Verzögerung einer Kette (1) von Nicht-Gliedern (2) mit einen sehr genau definierten Taktintervall,

b) eine digitale Regelschaltung mit einem Zweirichtungszähler (13), dessen Steuereingänge (Z1, Z2) an die Vergleichsschaltung angeschlossen sind, und nachfolgendem Decodierer (17), bei dem jeweils einer seiner Ausgänge (D1 bis D7) mit der Steuerelektrode eines angeordneten Transistors (T1 bis T7) verbunden ist und alle diese Transistoren mit ihren kollektorwiderständen (R1 bis R7) parallel zu dem einen Widerstand (R8) eines Spannungsteilers angeordnet sind, dessen Abgriff (D) mit der Basis eines Emitterfolgers (T8) verbunden ist, an dessen Emitter die Betriebsspannung abnehmbar ist, durch deren Größe die Signalverzögerung der monolithisch integrierten Halbleiterschaltungen beeinflußbar ist.

3. Vorrichting nach Anspruch 2, dadurch gekennzeichnet, daß der Decodierer (17) so aufgebaut ist, daß so viele seiner Ausgangsleitungen ein gewünschtes Potential aufweisen als dem Zählerstand entsprechen.

**Revendications**

1. Procédé d'ajustement des différents retards de signaux émix par des plaquettes semi-conductrices en modifiant une tension de service, caractérisé par les étapes suivantes:

a) comparaison du retard du signal émis par une chaîne (1) d'inverseurs (2) prévue en sus sur la microplaquette semi-conductrice aux fins de cet ajustement avec l'intervalle défini de façon précise existant entre deux signaux,

b) modification du contenu d'un compteur décompteur (13) disposé sur ladite microplaquette en fonction du résultat de la comparaison établie lors du comptage ou lors du décomptage,

c) décodage du contenu de comptage et modification du taux de division d'un diviseur de tension en fonction de contenu de comptage en mettant ou en ne mettant pas en service des résistances parallèles (R1 à R7), la prise (B) du diviseur de tension étant connectée à la base d'un émetteur suiveur (T8) dont l'émetteur fournit la tension de service dont la valeur définit le retard du signal des circuits montés sur la microplaquette semi-conductrice, et

d) réitération des étapes a) à c) dudit procédé jusqu'à ce que la différence Δt entre l'émission de l'impulsion d'horloge décalée et l'impulsion d'horloge normale suivante avoisine zéro.

2. Dispositif de mise en oeuvre dudit procédé selon la revendication 1, caractérisé en ce que chaque microplaquette semi-conductrice est dotée:

a) d'un circuit comparateur (4) afin de comparer le retard d'une chaîne (1) d'inverseurs (2) avec l'intervalle défini de façon précise entre deux signaux,

b) un circuit de commande numérique qui comporte, d'une part, un compteur-décompteur (13) dont les entrées de commande (Z1, Z2) sont connectées audit circuit comparateur et, d'autre part, un décodeur situé en amont dont chaque sortie (D1 à D7) est reliée à l'électrode de commande d'un transistor associé (T1 à T7), tous lesdits transistors et leurs résistances de collecteur (R1 à R7) étant disposés en parallèle avec une résistance (R8) d'un diviseur de tension dont la prise (D) est connectée à la base d'un émetteur-suiveur (T8) lequel fournit par son émetteur la tension de service dont la valeur détermine le retard du signal des circuits monolithiques intégrés semi-conducteurs.

3. Dispositif selon la revendication 2, caractérisé en ce que ledit décodeur (17) est conçu de telle sorte qu'un nombre de ses lignes de sortie correspondant au contenu de comptage a le potentiel souhaité.

**Claims**

1. Method of equalizing the different signal delay times of semiconductor chips by modifying an operating voltage, characterized by the following steps:

a) comparing the signal delay of a chain (1) of inverters (2) additionally provided for the equalizing on the semiconductor chip with a very precisely defined clock interval,
b) altering the count of an up-down counter (13) on the semiconductor chip in accordance with the comparison result in the one or in the other counting direction,
c) decoding the count and altering the divider ratio of a voltage divider depending on the count by the switching on or off of parallel resistors (R1 to R7), the tap (B) of that voltage divider being connected to the base of an emitter follower (T8) providing at its emitter the supply voltage whose value influences the signal delay of the semiconductor chip circuits, and
d) repeating process steps a) to c) until the difference t between the arrival of the delayed and of the subsequent undelayed clock pulses approaches zero.

2. Device for carrying out the method as claimed in claim 1, characterized in that on each semiconductor chip there are provided

a) a comparator circuit (4) with a very precisely defined clock interval
b) a digital control circuit with an up-down counter (13) whose control inputs (Z1, Z2) are connected to the comparator circuit, and with a following decoder (17) where one respective of its output (D1 to D7) is connected to the control electrode of an associated transistor (T1 to T7), and where all these transistors are arranged with their collector resistors (R1 to R7) in parallel to a resistor (R8) of a voltage divider having its tap (D) connected to the base of an emitter follower (T8) providing at its emitter the supply voltage whose value influences the signal delay of the monolithically integrated semiconductor circuits.

3. Device as claimed in claim 2, characterized in that the decoder (17) is structured in such a manner that the number of its output lines with a respective potential corresponds to the count.

FIG. 1

FIG. 2A

FIG. 2B

FIG. 3

$$D1 = A \vee B \vee C$$
$$D2 = B \vee C$$
$$D3 = (A \,\&\, B) \vee C$$
$$D4 = C$$
$$D5 = (A \vee B) \,\&\, C$$
$$D6 = B \,\&\, C$$
$$D7 = A \,\&\, B \,\&\, C$$

FIG. 4

| ZAHLERSTAND | | | ERREGTE AUSGANGSLEITUNGEN DES DECODIERERS |
|---|---|---|---|
| C | B | A | |
| 0 | 0 | 1 | D1 |
| 0 | 1 | 0 | D1, D2 |
| 0 | 1 | 1 | D1 --- D3 |
| 1 | 0 | 0 | D1 --- D4 |
| 1 | 0 | 1 | D1 --- D5 |
| 1 | 1 | 0 | D1 --- D6 |
| 1 | 1 | 1 | D1 --- D7 |

FIG. 5